# EUROPEAN PATENT SPECIFICATION

(11) **EP 1 997 228 B1**
(45) Date of publication and mention of the grant of the patent: **19.09.2012**
(21) Application number: 07747347.8
(22) Date of filing: 13.03.2007
(51) Int. Cl.: H03K 17/965

(54) **IMPROVED PIEZOELECTRIC SWITCH**
VERBESSERTER PIEZOELEKTRISCHER SCHALTER
INTERRUPTEUR PIÉZOÉLECTRIQUE AMÉLIORÉ

(30) Priority: 14.03.2006 NL 2000026
(43) Date of publication of application: 03.12.2008
(73) Proprietor: Aito B.V., 1506 GC Zaandam (NL)
(72) Inventor: DE VRIES, René, Marcel, NL-1506 JE Zaandam (NL); VAN DALEN, Ary, Hilbert, NL-1826 JA Alkmaar (NL)
(74) Representative: Väisänen, Olli Jaakko
(86) International application number: PCT/NL2007/050101
(87) International publication number: WO 2007/105950

(56) References cited:
- EP-A1- 1 103 432
- DE-A1- 2 125 068
- US-A- 4 328 441
- US-B1- 6 466 140

## Description

The invention relates to a piezoelectric switch, comprising at least a substantially flat first piezoelectric element, a substantially flat second piezoelectric element an operating unit that can move in the direction transverse to the principal plane of the first piezoelectric element for exerting a force on the first and the second piezoelectric element during operation, said force deforming the first and the second piezoelectric element, electrical connecting means connected to opposite sides of the first piezoelectric element for conducting signals generated by the first piezoelectric element during operation and electrical connecting means connected to opposite sides of the second piezoelectric element for conducting signals generated by the second piezoelectric element during operation.

Such switches are known from DE-A-21 25 068.

These switches belonging to the prior art are increasingly applied on account of their durability and resistance to vandalism. This makes these switches attractive for applications that place high requirements on the reliability of the switch, for example in applications whereby safety depends on the switch. Such applications are usually subject to legal requirements for the switches to be provided with two independent switching elements. In the prior art switch mentioned above this has been reached by placing two piezoelectric elements one above the other, whereby the top element can be operated by an operating element and by transferring the movement of the top element to the bottom element. In this switch the connection means are of one of the poles are connected within the switch as the crystals are located on the same support. The connections means of the other poles are mutually connected adjacent to the switch. Thus the independence of the both electrical circuits of both crystals is not ensured completely.

The aim of the present invention is to provide such a switch wherein the circuits of both crystals are implemented independently as far as possible.

This aim is reached in that the electrical connecting means of each piezoelectric element are at least adjacent to the switch galvanically separated from each other.

It turns out that the deformation of both elements is not the same, so that different magnitudes of piezoelectric voltage are generated, whereby the switch-on time also differs. There is also a risk of only one of the elements responding and generating a voltage when the operating element is pressed. The present invention attempts to avoid these problems.

This object is achieved in that at least a second piezoelectric element is positioned in the housing, said element being mechanically linked to the operating unit in such a way that when the operating unit is operated, a force is exerted on at least the first and second piezoelectric elements which mechanically deforms the piezoelectric elements, in that the at least second piezoelectric element is provided with electrical connecting means on its opposite sides for conducting signals generated by the second piezoelectric element during operation, and in that the electrical connecting means of each piezoelectric element are at least partially galvanically separated from each other. As a result of these measures, an equal mechanical load is exerted on the piezoelectric elements.

According to a first embodiment, the mechanical link between the operating unit and the second piezoelectric element is arranged for causing a deformation in the second piezoelectric element when the operating unit is pressed, said deformation being substantially equal to that of the first piezoelectric element. By means of these measures, the mechanical load of the elements is made as equal as possible for each element, so that the electrical signals generated by the elements are made as equal as possible to each other.

The mechanical structure of the switch is simplified if the first and second piezoelectric element are extended in parallel to each other and in a concentric fashion.

According to a further preferred embodiment, each of the piezoelectric elements comprises a piezoelectric crystal positioned on a carrier, a film is applied to the side of the element facing away from the carrier and at least the carrier of the element that is positioned closest to the operating element is suspended in the housing so that it can move in the direction in which the operating element moves. By means of this structure, the movement of the top element is easily transferred to the bottom element, so that the deformations of the elements are as equal as possible.

The similarity of the movements and deformations of either element is further increased, if the first and second piezoelectric elements are positioned with their carriers facing each other in the housing and if both carriers are suspended in the housing so that they can move in the direction in which the operating element moves.

A more specific preferred embodiment provides for the measure that the carriers are attached to a film that can move in the direction in which the operating unit moves at least at the edge of the carrier and that an electrically insulating film is applied between the carriers extending over at least a part of the surface of the carriers, with electrically conductive tracks being mounted on either side of the film, said tracks being arranged for functioning as part of the electrical connecting means. This measure makes it possible to meet the requirements with respect to separating the electrical circuits while maintaining a structurally attractive solution.

The measure of incorporating openings in the film simplifies the movement of the carriers and the piezoelectric elements positioned thereon.

The electrically insulating film is preferably clamped into position at its edges between two layers of the side wall of a housing in which the components of the switch are positioned. The structure is thus further simplified.

Yet another preferred embodiment provides for the measure that the film applied on the side of the element facing away from the carrier is produced out of electrically insulating material and that electrically conductive tracks are mounted on this film, which are arranged for functioning as part of the electrical connecting elements. In this way it is possible to provide the electrical connections in a relatively simple fashion while maintaining the galvanically separated circuits.

The voltage generated by a piezoelectric element is largely dependent on the temperature, which can lead to problems in a number of applications. To avoid these problems, an embodiment proposes providing at least a third piezoelectric element that is connected with opposite polarity and in series to the first piezoelectric element and is thermally linked at least to the first piezoelectric crystal. This thermal link ensures that the piezoelectric elements each have the same temperature, so that the temperature-dependent part of the voltage generated by the piezoelectric elements is the same as far as possible.

For the same reason, another preferred embodiment provides measures providing for at least a fourth piezoelectric element that is connected with opposite polarity and in series to the second piezoelectric element and is thermally linked at least to the second piezoelectric crystal.

In this respect it should be noted that it is in principle possible to also apply this thermal compensation switch in simple switches, in other words in switches where only one piezoelectric crystal is used.

To keep the temperature of the elements contained in a thermal compensation switch as constant as possible, it is attractive if at least one of the pairs of the first and third piezoelectric element or respectively second and fourth piezoelectric element are positioned on a carrier that can conduct heat effectively.

For the function referred to above to be effective, whereby the temperature is compensated, it is important for the second element only to have to fulfill its compensating function. This is possible if the third or respectively fourth piezoelectric element cannot be operated.

It is however also possible for the third and fourth piezoelectric elements to be joined to a structure corresponding to that of the first and second piezoelectric elements, for the first, second, third and fourth piezoelectric elements to each be connected to a circuit and for the circuit to only be effective if the combination of the first and second elements or the combination of the third and fourth elements is operated.

A piezoelectric switch comprises a piezoelectric element, the electrical connections of which are connected to an electronic circuit that is arranged to respond to the signal generated by the piezoelectric element. The electrical connections of the piezoelectric element are connected by a resistance. When used as a pulse generator, this resistance acts as a leakage resistance, which causes the charge generated as a result of the deformation of the piezoelectric element to drain away, in turn causing the voltage over the piezoelectric element to decrease. As a result of this, the circuit will produce a pulse starting at the point at which the voltage generated by the piezoelectric element exceeds a threshold value and ending when the voltage drops below this threshold value. A piezoelectric element continues to retain the voltage generated during the process of deformation even after it has been deformed. This means that each of the elements is provided with a resistance to allow the charge generated during the process of deformation to drain away.

It is however also possible to apply the piezoelectric elements in a switch having a permanent function. The configuration used to this end corresponds to that of the switch with pulse function described above, provided that the electronic circuit is arranged for switching off the resistance as soon as the threshold value referred to above is exceeded. The voltage generated by the piezoelectric element is then indeed retained. Particularly in the last case, it is important for the temperature to be compensated to avoid any undesired operation of the switches.

Further features of the present invention will emerge from the accompanying drawings, in which the following are shown:
Figure 1: a cross-sectional view of a first embodiment of a switch according to the invention in rest position;
Figure 2: a cross-sectional view of a variant of the switch shown in Figure 1 in actuated position;
Figure 3: a cross-sectional view of another variant of the switch shown in Figure 1 in actuated position;
Figure 4: a cross-sectional view of a second embodiment of a switch according to the invention in rest position;
Figure 5: a cross-sectional view of a third embodiment of a switch according to the invention in rest position; and
Figure 6: a cross-sectional view of a third embodiment of a switch according to the invention in rest position.

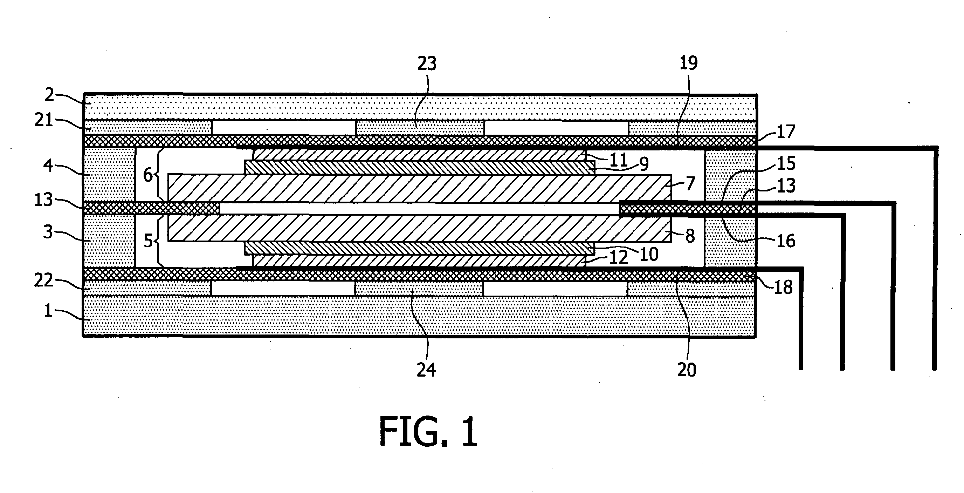

The piezoelectric switch shown in Figure 1 comprises a housing that is formed by a base plate 1 and a flexible operating plate 2 extending in parallel thereto, which are separated at their edges by two rings or spacers 3, 4. Two piezoelectric elements 5, 6 are positioned in the housing, each formed by a carrier 7, or respectively 8, produced out of an electrically conductive material, a piezoelectric crystal 9, 10 and a conductive layer 11, 12 applied thereto. Such piezoelectric elements are known per se. With the present invention, they are positioned back to back, in other words with their carriers 7, 8 facing each other.

The carriers 7, 8 are each connected to a film 13 of electrically insulating material. The edges of this film 13 are clamped into position between the spacers 3, 4. Conductive tracks 15, 16 are mounted on either side of the film 13 and are used to connect the corresponding side of the piezoelectric element 5, 6.

As a result of the difference in thickness between piezoelectric elements and spacers, the side of the elements 9, 10 on which the film layer 17, 18 is present is pressed against the electrically insulating film 17, 18 that is provided with a conductive track 19, 20. These tracks 19, 20 are also used to connect the corresponding side of the piezoelectric element 5, 6. The films 17, 18 are retained between the respective spacers 3, 4. A pressure piece 23, or respectively 24, is affixed to the center of the base plate 1, or respectively operating plate 2.

This piezoelectric switch functions as follows: The switch is operated by pressing the operating plate 2. This causes the center of the plate to move downwards, with the pressure piece 23 being included in this movement. This vertical movement is distributed equally over both piezo elements as a result of the symmetrical structure. Both piezoelectric elements 5, 6 are thus deformed and both crystals 9, 10 generate substantially the same voltage at substantially the same time. In this respect, the elastic suspension of the piezoelectric elements is important to enable the piezoelectric elements to move in the direction of operation. This elastic suspension is achieved by the presence of the elastic films 13, 17 and 18. Although in this exemplary embodiment, the piezoelectric elements are positioned as mirror images, it is also perfectly possible to position the elements one under the other without rotating either.

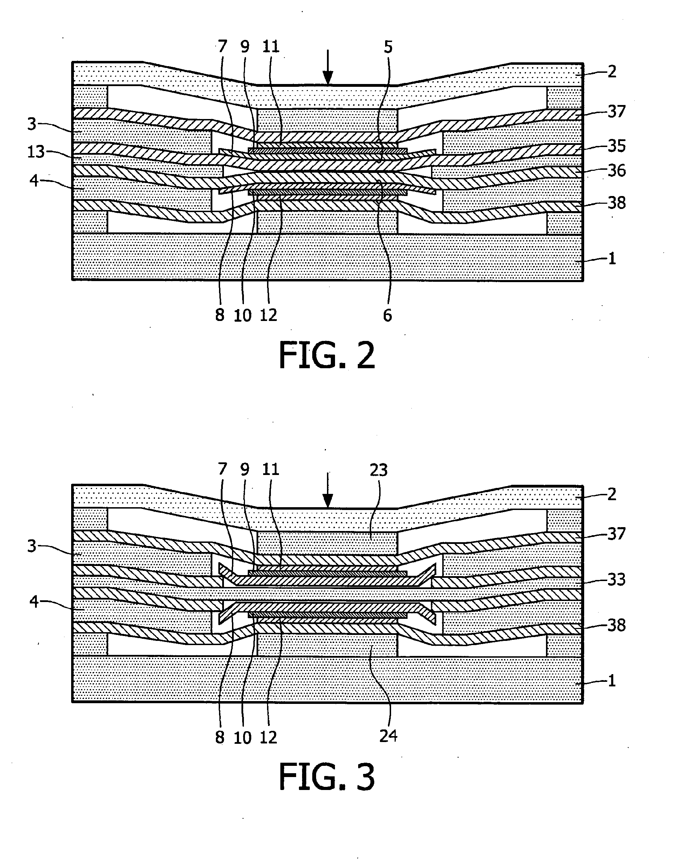

Figure 2 shows a slightly changed configuration, this time in the actuated position. In this configuration - apart from the dimensioning - an electrically conductive film 37, or respectively 38, is applied instead of an insulating film 17, or respectively 18 on which conductive tracks are mounted. In addition, an electrically conductive film 35, or respectively 36, is applied to either side of the insulating film 13, fulfilling the function of tracks 15, 16 from an electrical perspective. An extra spacer is also added with a ring-shaped air chamber, freeing up space between the piezoelectric elements to bend toward each other.

A further slightly changed configuration is shown in Figure 3. In this configuration, film 13 with a round recess between the carriers 7, 8 is replaced by a spacer 33 without any opening, thus obtaining better electrical insulation between the electrical circuits connected to the various piezoelectric crystals.

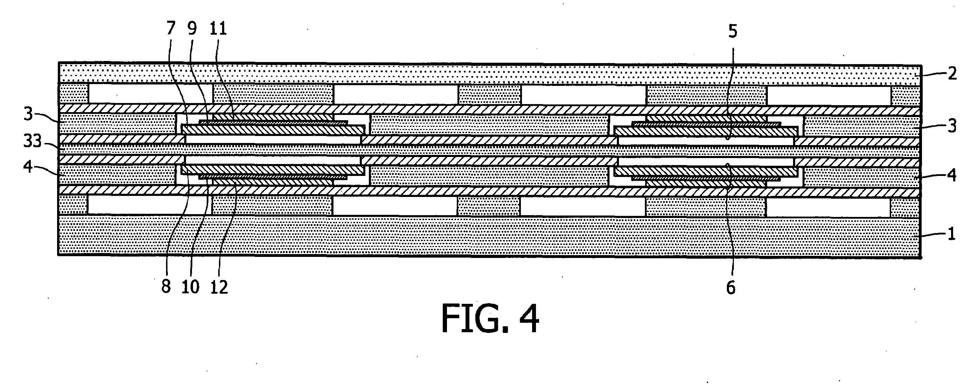

Figure 4 shows a combination of two switches according to the embodiment of Figure 3. In this configuration, one of the switches is used to compensate the thermal drift of the piezoelectric crystals. To this end, a crystal in the left switch is connected with opposite polarity and in series to one of the crystals in the right switch. The conductors are therefore connected through to the corresponding films.

Such a switch is suitable for switching functions on and off, whereby one of the switches is used for switching on the function and the other switch is used for switching off the function in question. From a functional perspective, this prevents the left and right switch from being operated at the same time. However, if such a switching operation does happen, it will not have any consequences.

It should be noted in this respect that a non-operated piezoelectric crystal displays thermal drift in the same way as an operated piezoelectric crystal. If both are connected with opposite polarity and in series, the thermal drift voltages will compensate each other, so that the resultant voltage is independent of the temperature.

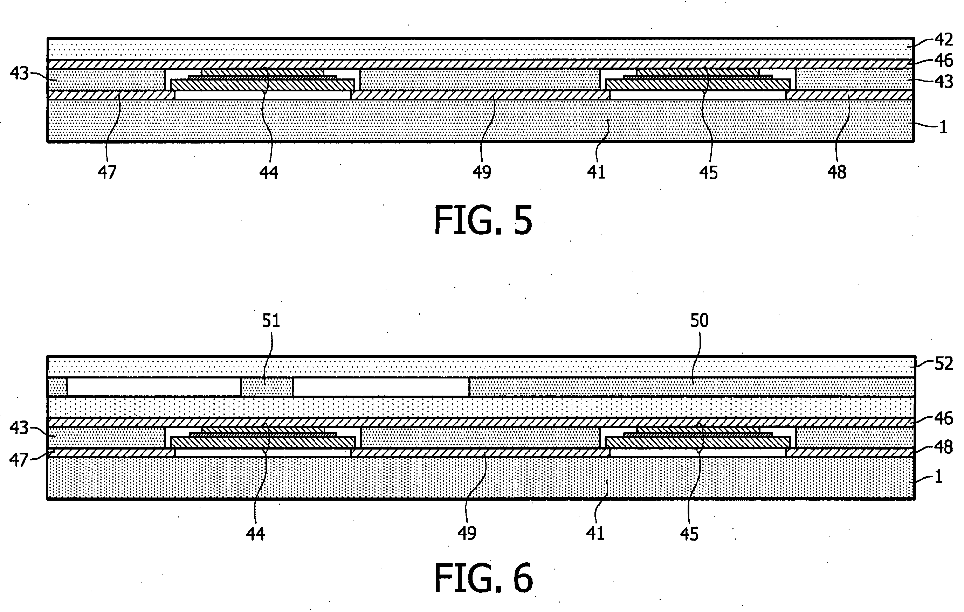

In the configuration according to Figure 4, it is possible to refer to a duplicate arrangement of switches creating the redundancy required for safety-critical applications. However, it is also possible to use simple switches with temperature compensation, as shown in Figure 5, whereby the base plate and bottom film with conductor are replaced with a printed circuit board having conductors on its upper side to conduct the current away.

The switch in question comprises a printed circuit board 41, a flexible operating plate 42 and a spacer 43 positioned between the films 46 and 47. Two piezoelectric elements 44 and 45 are arranged inside the switch.
The upper side of the piezoelectric elements is connected by conductor 46 and the bottom side of the first piezoelectric element 44 is connected to the electronic circuit via a conductive films 47 on the printed circuit board 41. The bottom side of the second piezoelectric element 45 is connected to the circuit via a conductor 48 on the printed circuit board. As a result of this configuration, both piezoelectric crystals are connected in series. This embodiment also includes the provision that only one of the piezoelectric elements is operated at any one time.

Finally, Figure 6 shows an embodiment in which only one of the piezoelectric elements, namely element 44, can be operated. In comparison with the configuration shown in Figure 5, a spacer body 50 is positioned extending above the non-operable piezoelectric element 45 and a pressure piece 51 is positioned above the operable element. The overall structure is covered by a cover plate 52 that is flexible in one direction. This means that the element 45 cannot be operated, so it is always only used as a compensator for the temperature.

It should be noted that there are numerous ways of deviating from the configurations shown above, without departing from the scope of the invention.

## Claims

1. Piezoelectric switch, comprising:
- a housing;
- at least a substantially flat first piezoelectric element positioned in the housing;
- at least a substantially flat second piezoelectric element positioned in the housing;
- an operating unit that can move in the direction transverse to the principal plane of the first piezoelectric element for exerting a force on the first and the second piezoelectric element during operation, said force reforming the first and the second piezoelectric element; and
- electrical connecting means connected to opposite sides of the first piezoelectric element for conducting the signals generated by the first piezoelectric element when the first piezoelectric element is deformed,
- electrical connecting means connected to opposite sides of the second piezoelectric element for conducting the signals generated by the second piezoelectric element when the second piezoelectric element is deformed,
**characterized in that** the electrical connecting means of each piezoelectric element are at least adjacent to the switch galvanically separated from each other.

2. Piezoelectric switch according to claim 1, **characterized in that** the first piezoelectric element is substantially identical to the second piezoelectric element and that the mechanical link between the operating unit and the second piezoelectric element is arranged for causing a deformation in the second piezoelectric element when the operating unit is pressed, said deformation being substantially equal to that of the first piezoelectric element.

3. Piezoelectric switch according to claim 2, **characterized in that** the first and second piezoelectric elements extend mutually parallel and in concentric fashion.

4. Piezoelectric switch according to claim 3, **characterized in that** each of the piezoelectric elements comprises a piezoelectric crystal positioned on a carrier, **in that** a film is applied to the side of the crystal facing away from the carrier and **in that** at least the carrier of the crystal that is positioned closest to the operating element is suspended in the housing so that it can move in the direction in which the operating element moves.

5. Piezoelectric switch according to claim 4, **characterized in that** the first and second piezoelectric elements are positioned in the housing with their carriers facing each other and **in that** both carriers are suspended in the housing so that they can move in the direction in which the operating element moves.

6. Piezoelectric switch according to claim 5, **characterized in that** the carriers are attached to a film that is movable in the direction in which the operating unit moves at least at the edge of the carrier and **in that** an electrically insulating film is applied between the carriers extending over at least a part of the surface of the carriers, with electrically conductive tracks being mounted on either side of the film, said tracks being arranged for functioning as part of the electrical connecting means.

7. Piezoelectric switch according to claim 6, **characterized in that** openings are incorporated in the film.

8. Piezoelectric switch according to claim 6 or 7, **characterized in that** electrically insulating film is clamped into position at its edges between two layers of the side wall of a housing in which the components of the switch are positioned.

9. Piezoelectric switch according to claim 6, 7 or 8, **characterized in that** the film applied on the side of the element facing away from the carrier is produced out of electrically insulating material and that electrically conductive tracks are mounted on this film which are arranged for functioning as part of the electrical connecting elements.

10. Piezoelectric switch according to claim 9, **characterized in that** at least a third piezoelectric element connected with opposite polarity and in series to the first piezoelectric element and **in that** the first and third piezoelectric elements are at least thermally interconnected.

11. Piezoelectric switch according to claim 10, **characterized in that** at least a fourth piezoelectric element connected with opposite polarity and in series to the second piezoelectric element and **in that** the second and fourth piezoelectric elements are at least thermally interconnected.

12. Piezoelectric switch according to claim 10 or 11, **characterized in that** at least one of the pairs of the first and third piezoelectric elements or respectively the second and fourth piezoelectric elements are positioned on a carrier conducting heat effectively.

13. Piezoelectric switch according to claim 12, **characterized in that** the third and fourth piezoelectric elements cannot be operated.

14. Piezoelectric switch according to claim 13, **characterized in that**
- the third and fourth piezoelectric elements are joined to a structure corresponding to that of the first and second piezoelectric elements,
- the first, second, third and fourth piezoelectric elements are each connected to a circuit, and
- the circuit is only effective if the combination of the first and second elements or the combination of the third and fourth elements is operated.

15. Piezoelectric switch according to any one of the preceding claims, **characterized in that** the switch is arranged for implementing a permanent switching function.

## Patentansprüche

1. Piezoelektrischer Schalter, der folgendes umfasst:
- ein Gehäuse;
- mindestens ein im Wesentlichen flaches erstes piezoelektrisches Element, das im Gehäuse positioniert ist;
- mindestens ein im Wesentlichen flaches zweites piezoelektrisches Element, das im Gehäuse positioniert ist;
- eine Betätigungseinheit, die sich zur Hauptebene des ersten piezoelektrischen Elements in transversaler Richtung bewegen kann, um während der Betätigung eine Kraft auf das erste und das zweite piezoelektrische Element auszuüben, wobei diese Kraft das erste und das zweite piezoelektrische Element verformt; und
- elektrische Anschlussmittel, die an den gegenüberliegenden Seiten des ersten piezoelektrischen Elements angeschlossen sind, um die vom ersten piezoelektrischen Element erzeugten Signale zu leiten, wenn das erste piezoelektrische Element verformt ist,
- elektrische Anschlussmittel, die an den gegenüberliegenden Seiten des zweiten piezoelektrischen Elements angeschlossen sind, um die vom zweiten piezoelektrischen Element erzeugten Signale zu leiten, wenn das zweite piezoelektrische Element verformt ist,
**dadurch gekennzeichnet, dass** die elektrischen Verbindungsmittel eines jeden piezoelektrischen Elements zumindest angrenzend an den Schalter galvanisch voneinander getrennt sind.

2. Piezoelektrischer Schalter nach Anspruch 1, **dadurch gekennzeichnet, dass** das erste piezoelektrische Element mit dem zweiten piezoelektrischen Element im Wesentlichen identisch ist und dass die mechanische Verbindung zwischen der Betätigungseinheit und dem zweiten piezoelektrischen Element so angeordnet ist, dass sie eine Verformung im zweiten piezoelektrischen Element hervorruft, wenn die Betätigungseinheit gedrückt ist, wobei die Verformung im Wesentlichen der des ersten piezoelektrischen Elements gleicht.

3. Piezoelektrischer Schalter nach Anspruch 2, **dadurch gekennzeichnet, dass** das erste und zweite piezoelektrische Element parallel zueinander und in konzentrischer Weise verlaufen.

4. Piezoelektrischer Schalter nach Anspruch 3, **dadurch gekennzeichnet, dass** jedes der piezoelektrischen Elemente einen piezoelektrischen Kristall umfasst, der auf einem Träger positioniert ist, dadurch, dass ein Film an der Seite des Kristalls angebracht ist, die vom Träger weg zeigt und dadurch, dass mindestens der Träger des Kristalls, der dem Betätigungselement am Nächsten liegt, im Gehäuse gelagert ist, so dass es sich in die Richtung bewegen kann, in die sich das Betätigungselement bewegt.

5. Piezoelektrischer Schalter nach Anspruch 4, **dadurch gekennzeichnet, dass** das erste und zweite piezoelektrische Element im Gehäuse mit einander zugewandten Trägern positioniert sind und dadurch, dass beide Träger im Gehäuse gelagert sind, so dass sie sich in die Richtung bewegen können, in die sich das Betätigungselement bewegt.

6. Piezoelektrischer Schalter nach Anspruch 5, **dadurch gekennzeichnet, dass** die Träger auf einem Film befestigt sind, der in die Richtung bewegbar ist, in die sich die Betätigungseinheit bewegt zumindest an der Kante des Trägers und dadurch, dass ein elektrisch isolierender Film zwischen den Trägern angebracht ist, der zumindest über einen Teil der Oberfläche der Träger verläuft, mit elektrisch leitenden Spuren, die auf beiden Seiten des Films aufgebracht sind, wobei die Spuren so angeordnet sind, dass sie als Teil der elektrischen Anschlussmittel wirken.

7. Piezoelektrischer Schalter nach Anspruch 6, **dadurch gekennzeichnet, dass** in den Film Öffnungen eingearbeitet sind.

8. Piezoelektrischer Schalter nach Anspruch 6 oder 7, **dadurch gekennzeichnet, dass** elektrisch isolierender Film an seinen Kanten zwischen zwei Schichten der Seitenwand eines Gehäuses, in dem die Komponenten des Schalters positioniert sind, an Ort und Stelle eingeklemmt ist.

9. Piezoelektrischer Schalter nach Anspruch 6, 7 oder 8, **dadurch gekennzeichnet, dass** der Film, der an der vom Träger abgewandten Seite des Elements angebracht ist, aus elektrisch isolierendem Material hergestellt ist und dass elektrisch leitende Spuren auf diesem Film aufgebracht sind, die so angeordnet sind, dass sie als Teil der elektrischen Anschlusselemente wirken.

10. Piezoelektrischer Schalter nach Anspruch 9, **dadurch gekennzeichnet, dass** zumindest ein drittes piezoelektrisches Element mit gegensätzlicher Polarität angeschlossen und mit dem ersten piezoelektrischen Element in Reihe geschaltet ist und dadurch, dass das erste und dritte piezoelektrische Element zumindest thermisch miteinander verbunden sind.

11. Piezoelektrischer Schalter nach Anspruch 10, **dadurch gekennzeichnet, dass** zumindest ein viertes piezoelektrisches Element mit gegensätzlicher Polarität angeschlossen und mit dem zweiten piezoelektrischen Element in Reihe geschaltet ist und dadurch, dass das zweite und vierte piezoelektrische Element zumindest thermisch miteinander verbunden sind.

12. Piezoelektrischer Schalter nach Anspruch 10 oder 11, **dadurch gekennzeichnet, dass** zumindest eines der Paare aus erstem und drittem piezoelektrischen Element oder beziehungsweise zweitem und viertem piezoelektrischen Element auf einem Träger positioniert ist, der Wärme effektiv leitet.

13. Piezoelektrischer Schalter nach Anspruch 12, **dadurch gekennzeichnet, dass** das dritte und vierte piezoelektrische Element nicht betätigt werden können.

14. Piezoelektrischer Schalter nach Anspruch 13, **dadurch gekennzeichnet, dass**
- das dritte und vierte piezoelektrische Element an einer Konstruktion befestigt sind, die der des ersten und zweiten piezoelektrischen Elements entspricht,
- das erste, zweite, dritte und vierte piezoelektrische Element jeweils an einen Stromkreis angeschlossen sind, und
- der Stromkreis nur geschlossen ist, falls die Kombination aus erstem und zweitem Element oder die Kombination aus drittem und viertem Element betätigt ist.

15. Piezoelektrischer Schalter nach einem der vorhergehenden Ansprüche, **dadurch gekennzeichnet, dass** der Schalter zum Ausführen einer dauerhaften Schaltfunktion angeordnet ist.

## Revendications

1. Interrupteur piézoélectrique comprenant :
- un boîtier ;
- au moins un premier élément piézoélectrique plat logé dans le boîtier ;
- au moins un deuxième élément piézoélectrique plat logé dans le boîtier ;
- une unité de fonctionnement qui peut effectuer un déplacement transversal par rapport au plan principal du premier élément piézoélectrique afin d'exercer au cours du fonctionnement une force sur le premier et le deuxième élément piézoélectrique, laquelle force déforme le premier et le deuxième élément piézoélectrique ; et
- un moyen de connexion électrique connecté aux côtés opposés du premier élément piézoélectrique afin de transférer les signaux générés par le premier élément piézoélectrique lorsque le premier élément piézoélectrique est déformé,
- un moyen de connexion électrique connecté aux côtés opposés du deuxième élément piézoélectrique afin de transférer les signaux générés par le deuxième élément piézoélectrique lorsque le deuxième élément piézoélectrique est déformé,
**caractérisé en ce que** les moyens de connexion électrique de chacun des éléments piézoélectriques sont séparés galvaniquement l'un de l'autre au moins de manière adjacente à l'interrupteur.

2. Interrupteur piézoélectrique selon la revendication 1, **caractérisé en ce que** le premier élément piézoélectrique est identique au deuxième élément piézoélectrique et **en ce que** la liaison mécanique entre l'unité de fonctionnement et le deuxième élément piézoélectrique est réalisée de sorte à déformer le deuxième élément piézoélectrique par pression de l'unité de fonctionnement, ladite déformation étant identique à celle du premier élément piézoélectrique.

3. Interrupteur piézoélectrique selon la revendication 2, **caractérisé en ce que** le premier et le deuxième éléments piézoélectriques se prolongent mutuellement parallèlement et de manière concentrique.

4. Interrupteur piézoélectrique selon la revendication 3, **caractérisé en ce que** chacun des éléments piézoélectriques comprend un cristal piézoélectrique placé sur un support, un film étant appliqué sur la partie du cristal opposée au support et le support du cristal le plus proche de l'unité de fonctionnement étant suspendu dans le boîtier de sorte à pouvoir se déplacer dans la même direction que l'unité de fonctionnement.

5. Interrupteur piézoélectrique selon la revendication 4, **caractérisé en ce que** le premier et le deuxième éléments piézoélectriques sont placés dans le boîtier de sorte à ce que leurs supports respectifs soient placés face à face et que les deux supports soient suspendus dans le boîtier de sorte à pouvoir se déplacer dans la même direction que l'unité de fonctionnement.

6. Interrupteur piézoélectrique selon la revendication 5, **caractérisé en ce que** les supports sont attachés à un film pouvant se déplacer dans la même direction que l'unité de fonctionnement au moins sur le bord du support, un film électriquement isolant appliqué entre les supports recouvrant au moins partiellement la surface des supports, et des pistes conductrices étant montées sur l'une des faces du film, lesdites pistes étant réalisées de sorte à fonctionner comme un élément des moyens de connexion électrique.

7. Interrupteur piézoélectrique selon la revendication 6, **caractérisé en ce que** des ouvertures sont intégrées au film.

8. Interrupteur piézoélectrique selon la revendication 6 ou la revendication 7, **caractérisé en ce que** les bords du film électriquement isolant sont fixés entre deux couches de la paroi du boîtier dans lequel les composants de l'interrupteur sont logés.

9. Interrupteur piézoélectrique selon la revendication 6, la revendication 7 ou la revendication 8, **caractérisé en ce que** le film appliqué sur le côté de l'élément opposé au support est réalisé avec un matériau électriquement isolant, des pistes conductrices étant montées sur ledit film de sorte à fonctionner comme un élément des moyens de connexion électrique.

10. Interrupteur piézoélectrique selon la revendication 9, **caractérisé en ce qu'**au moins un troisième élément piézoélectrique est raccordé en polarité inversée et en série au premier élément piézoélectrique, le premier et le troisième éléments piézoélectriques étant au moins reliés par une interconnexion thermique.

11. Interrupteur piézoélectrique selon la revendication 10, **caractérisé en ce qu'**au moins un quatrième élément piézoélectrique est raccordé en polarité inversée et en série au deuxième élément piézoélectrique, le deuxième et le quatrième éléments piézoélectriques étant au moins reliés par une interconnexion thermique.

12. Interrupteur piézoélectrique selon la revendication 10 ou la revendication 11, **caractérisé en ce qu'**au moins l'une des paires constituées du premier et du troisième éléments piézoélectriques ou respectivement du deuxième et du quatrième élément piézoélectrique sont situés sur un support disposant d'une conductivité thermique effective.

13. Interrupteur piézoélectrique selon la revendication 12, **caractérisé en ce que** le troisième et le quatrième éléments piézoélectriques ne peuvent être mis en oeuvre.

14. Interrupteur piézoélectrique selon la revendication 13, **caractérisé en ce que**
- le troisième et le quatrième éléments piézoélectriques sont raccordés dans une structure similaire à celle du premier et du deuxième éléments piézoélectriques,
- le premier, le deuxième, le troisième et le quatrième éléments piézoélectriques sont tous connectés à un circuit, et
- le circuit n'est efficace que lorsque la combinaison du premier et du deuxième éléments ou la combinaison du troisième et du quatrième éléments est mise en oeuvre.

15. Interrupteur piézoélectrique selon l'une quelconque des revendications précédentes, **caractérisé en ce que** l'interrupteur est conçu de sorte à remplir une fonction de commutation permanente.
